# EUROPEAN PATENT APPLICATION

(11) **EP 1 855 121 A1**
(43) Date of publication of application: **14.11.2007**
(21) Application number: 07251750.1
(22) Date of filing: 25.04.2007
(51) Int. Cl.: G01R 27/18

(54) **Method of testing an electrical connection**

(30) Priority: 09.05.2006 GB 0609123
(71) Applicant: Seaward Electronic Limited, 18 Bracken Hill, South West Industrial Estate Peterlee County Durham, SR8 2SW (GB)
(72) Inventor: Archbold, Simon Peter, Whitley Bay Tyne & Wear NE25 8TG (GB)
(74) Representative: Vinsome, Rex Martin

(57) **Abstract**

A test apparatus comprises a first circuit 30 which comprises a high frequency AC source 32 for providing a high frequency alternating current to coil 24. A ferrite ring 26 passes through coil 24 and around electrical connection 28 of the test apparatus to induce a voltage in electrical connection 28 when alternating current flows in coil 24. A voltmeter 34 is connected across resistor 36 to measure the voltage across resister 36. Electrical connection 28 comprises an earth connection 38 and contacts 22 which are adapted to connect to the earth strip 10 of a plug.

## Description

The present invention relates to a method of testing an electrical connection, and relates particularly, but not exclusively, to a method of testing the earth connection of an electrical plug.

A SCHUKO (registered trade mark) type plug comprises two round pins for live and neutral contacts, and may also comprise two flat contact areas on the top and bottom side of the plug for the protective earth connection. A SCHUKO (registered trade mark) socket is formed in the shape of a cavity into which the SCHUKO (registered trade mark) plug can be inserted. In order Lo test Lhe resistance of the protective earth contacts, a resistance measurement can be Laken by connecting the earth contacts on the periphery of the plug to a resistance measurement apparatus. If the resistance measured is below a predetermined value, then the earth connection of the SCHUKO (registered trade mark) plug is in working order.

The present invention seeks to provide an improved method of testing the earth connection of a SCHUKO (registered trade mark) type electrical plug.

According to an aspect of the present invention, there is provided a method of testing an electrical connection, the method comprising:-
inducing a respective first voltage signal in at least one first electrical conductor having first and second terminals connected to an electrical connection to be tested; and
detecting an electrical signal derived from at least one second electrical conductor electromagnetically coupled to at least one said first conductor such that current flowing in said first conductor induces a second voltage signal in said second conductor.

By inducing a first voltage signal in a first electrical conductor having first and second terminals connected to the electrical connection to be tested, if the electrical connection to be tested closes the first and second terminals to complete a circuit, then current will flow in the first electrical conductor. Changes in the current in the first electrical conductor will induce an associated voltage signal in a second conductor electromagnetically coupled to the first conductor. Detecting an electrical signal related to Lhe second voltage can therefore be used to determine whether the electrical connection Lo be tested is complete. This provides the advantage of eliminating the need for a resistance measurement of the electrical connection to be tested thus providing a simpler method of testing the electrical connection. By avoiding the necessity of a resistance measurement, this also provides the advantage that a standard SCHUKO (registered trade mark) type socket can be used in the apparatus, without the need to modify the electrical connections of the socket. Avoiding the need to modify electrical connections may in some jurisdictions assist in obtaining the necessary regulatory approval of the apparatus.

In a preferred embodiment, at least one said second conductor comprises at least one respective coil and inducing a first voltage signal in at least one said first electrical conductor comprises passing an alternating current through at least one said coil to induce said first voltage signal, such that induced current flowing in said first conductor mutually induces a said second voltage signal in at least one second conductor.

This provides the advantage that at least one said second conductor can be used to both induce the first voltage in a first conductor having terminals for connection to the electrical connection to be tested, and can also be used to detect an electrical signal derived from any current flowing in the connection to be tested. This means that a single circuit can be used to both excite a signal, 1. to be detected and also detect that signal. This simplifies the method of detection.

Detecting said electrical signal may comprise detecting at least one said second voltage signal.

The electrical connection to be tested may comprise the earth connection of an electrical plug.

According to a further aspect of the present invention there is provided an apparatus for testing an electrical connection, the apparatus comprising:-
means for inducing a first voltage signal in at least one first electrical conductor having first and second terminals connectable to an electrical connection to be LesLed; and
means for detecting an electrical signal derived from at least one second conductor electromagnetically coupled to at least one said first conductor such that current flowing in said first conductor induces a second voltage signal in said second conductor.

This provides the advantage of simplifying the testing of an electrical connection by eliminating the need to perform a resistance measurement of that electrical connection.

In a preferred embodiment, the means for inducing a first voltage signal comprises an AC voltage source and at least one coil connected to at least one said second conductor for inducing said first voltage in at least one said first electrical conductor.

The means for detecting may comprise a voltmeter for detecting at least one said second voltage signal.

Said voltmeter may be connected to at least one said second conductor across a resistor.

In a preferred embodiment, the apparatus further comprises a ferrite ring passing through at least one said coil and electromagnetically coupled to at least one said first conductor,
Said first and second terminals may be adapted to be connected to the earth connection of an electrical plug.

A preferred embodiment of the invention will now be described, by way of example only, and not in any limitative sense, with reference to the accompanying drawings in which:-
Figure 1 is a perspective view of a SCHUKO (registered trade mark) type electrical plug;
Figure 2 is a partial side view of part of an apparatus embodying the present invention for testing the earth connection of the plug of Figure 1;
Figure 3 is a front view of the apparatus of Figure 2 viewed in the direction of line A of Figure 2; and
Figure 4 is a circuit diagram of the earth detection circuit of the apparatus of Figures 2 and 3.

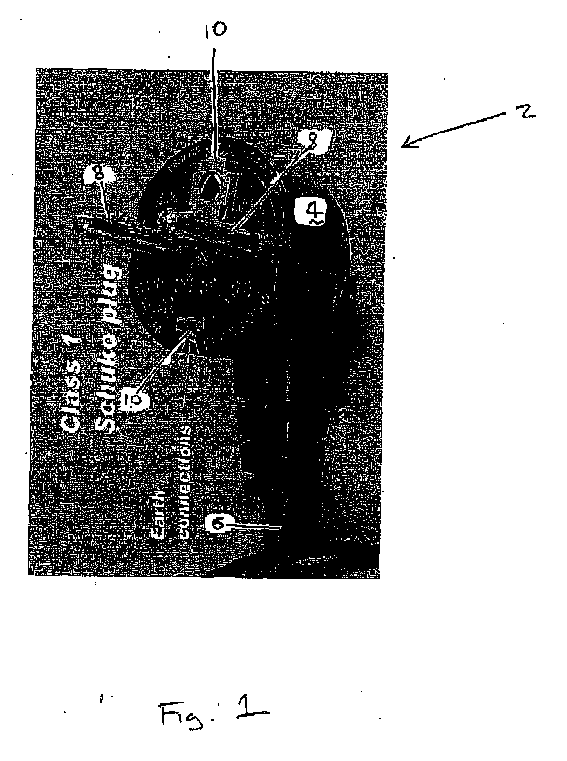

Referring to Figure 1, a SCHUKO (registered trade mark) plug shown generally by 2 comprises a plastic housing 4 and a lead 6 for connecting the plug 2 to an electrical appliance (not shown). Two circular pins 8 for the live and neutral connections project from housing 4. The earth connection of the plug comprises a metallic strip 10 which extends into the housing 4.

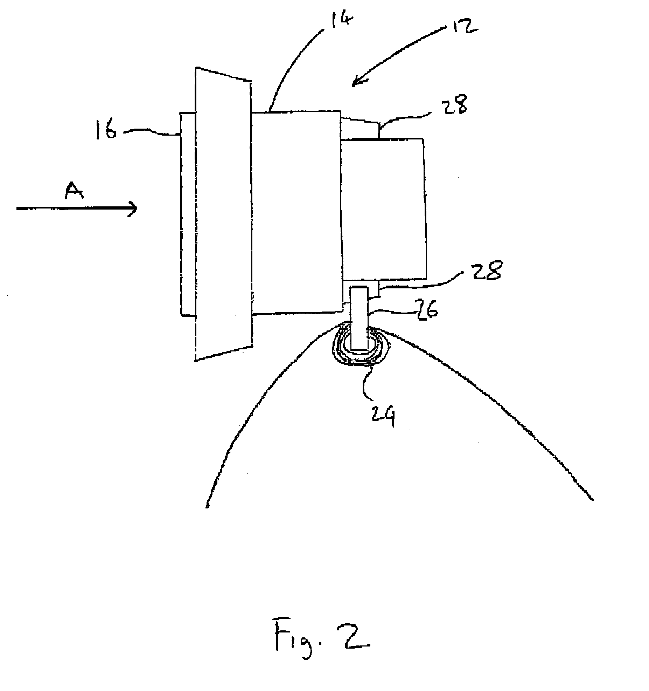

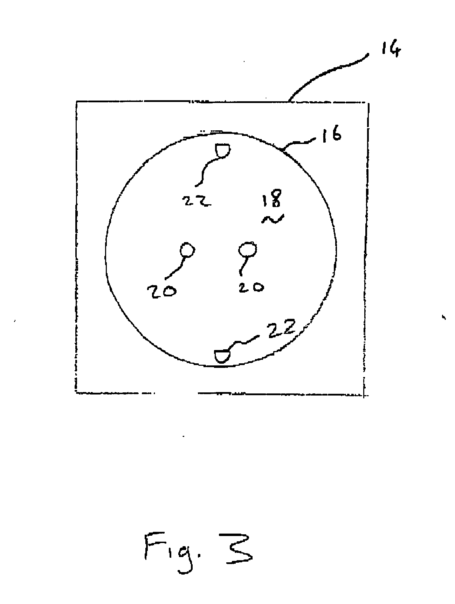

Referring to figures 2 and 3, a plug earth connection Lest apparatus shown generally by 12 comprises a housing 14 which may be formed from thermoplastics material. Housing 14 comprises a collar portion 16 which defines a circular aperture 18 into which the SCHUKO (registered trade mark) plug 2 fits. The collar portion 16 is preferably formed from a conventional SCHUKO (registered trade mark) type socket. Two circular holes 20 are disposed in the circular aperture 18 for receiving the pins 8 of the SCHUKO (registered trade mark) plug 2. Two electrical conLacLs 22 are disposed in the circular aperture 18 for contacting the earth strip 10 of the SCHUKO (registered trade mark) plug 2. The SCHUKO (registered trade mark) plug 2 can be plugged into the aperture 18 in the manner that the plug 2 would be plugged into an electrical wall socket.

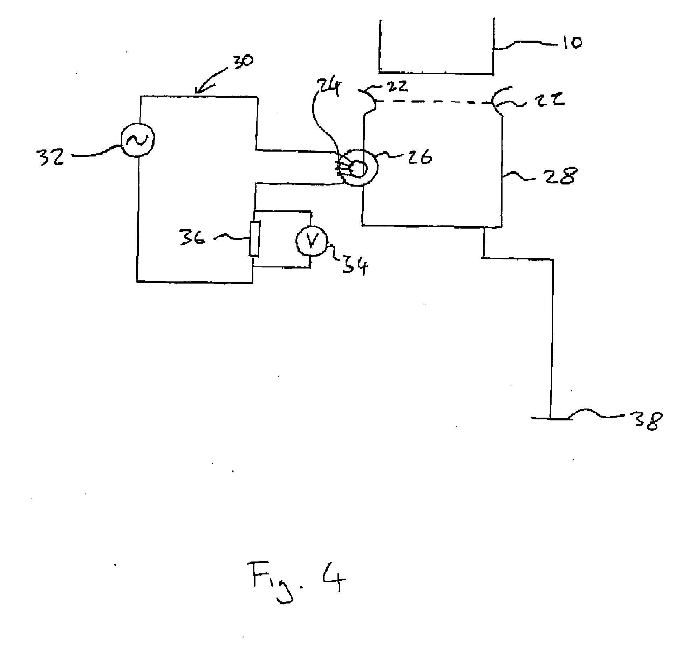

An electrical coil 24 forms part of a tester circuit (Figure 4). A ferrite ring 26 electromagnetically couples coil 24 to an electrical connection 28 of the test apparatus 12. Electrical connection 28 is connected at each end to contacts 22 (Figure 3).

Referring to Figure 4, the test apparatus comprises a first circuit shown generally by reference numeral 30 which comprises a high frequency AC source 32 for providing a high frequency alternating current to coil 24. A ferrite ring 26 passes through coil 24 and around electrical connection 28 of the test apparatus to induce a voltage in electrical connection 28 when alternating current flows in coil 24. A voltmeter 34 is connected across resistor 36 to measure the voltage across resister 36. Electrical connection 28 comprises an earth connection 38 and contacts 22 which are adapted to connect to the earth strip 10 of a SCHUKO (registered trade mark) plug (Figure 1).

Referring to Figures 1 to 4, the method of testing whether the earth connection of a SCHUKO (registered trade mark) plug is working will now be described.

SCHUKO (registered trade mark) plug 2 is inserted into circular aperture 18 of the test apparatus 14 such that pins 8 are received in circular holes 20 and contacts 22 connect to the earth strip 10 of the SCHUKO (registered trade mark) plug 2. High frequency AC source 32 is activated and the alternating current set up in coil 24 induces a voltage into electrical connection 28. If earth strip 10 is present and complete such that electrical connection 28 and earth strip 10 of the plug 2 form a circuit, a current will begin to flow in electrical connection 28. Any current flowing in electrical connection 2B will by mutual inductance induce a back EMF into the test circuit 30. This back EMF will result in a measurable change in the voltage across resistor 36 which Can be detected by voltmeter 34 to indicate the presence of the earth connection 10.

If the earth connection 10 is either not present or broken, then no back EMF will be registered by voltmeter 34 indicating an incomplete earth connection.

It will be appreciated by persons skilled in the art that the above embodiment has been described by way of example only and not in any limitative sense, and that various alterations and modifications are possible without departure from the scope of the invention as defined by the appended claims. In particular, although the above embodiment has been described in connection with a SCHUKO (registered trade mark) type plug, the invention is not limited to being used to measure the earth connection of a SCHUKO (registered trade mark) plug and may also be employed to measure earth connections of other types of plugs with different pin configurations. The apparatus may also be used to measure the completeness of any electrical connection.

## Claims

1. A method of testing an electrical connection, the method comprising:-
inducing a respective first voltage signal in at least one first electrical conductor having first and second terminals connected to an electrical connection to be tested; and
detecting an electrical signal derived from at least one second electrical conductor electromagnetically coupled to at least one said first conductor such that current flowing in said first conductor induces a second voltage signal in said second conductor.

2. A method according to claim 1, wherein at least one said second conductor comprises at least one respective coil and inducing a first voltage signal in at least one said first electrical conductor comprises passing an alternating current through at least one said coil to induce said first voltage signal, such that induced current flowing in said first conductor mutually induces a said second voltage signal in at least one second conductor.

3. A method according to claim 1 or 2, wherein detecting said electrical signal comprises detecting at least one said second voltage signal.

4. A method according to any one of the preceding claims, wherein the electrical connection to be tested comprises the earth connection of an electrical plug.

5. A method of testing an electrical connection, the method substantially as hereinbefore described with reference to Figures 2 to 4 of the accompanying drawings.

6. An apparatus for testing an electrical connection, the apparatus comprising:-
means for inducing a first voltage signal in at least one first electrical conductor having first and second terminals connectable to an electrical connection to be tested; and
means for detecting an electrical signal derived from at least one second conductor electromagnetically coupled to at least one said first conductor such that current flowing in said first conductor induces a second voltage signal in said second conductor.

7. An apparatus according to claim 6, wherein the means for inducing a first voltage signal comprises an AC voltage source and at least one coil connected to at least one said second conductor for inducing said first voltage in at least one said first electrical conductor.

8. An apparatus according to claim 7, further comprising a ferrite ring passing through at least one said coil and electromagnetically coupled to at least one said first conductor.

9. An apparatus according to any one of claims 6 to 8, wherein the means for detecting comprises a voltmeter for detecting at least one said second voltage signal.

10. An apparatus according to claim 9, wherein said voltmeter is connected to at least one said second conductor across a resistor.

11. An apparatus according to any one of claims 6 to 10, wherein said first and second terminals are adapted to be connected to the earth connection of an electrical plug.

12. An apparatus for testing an electrical connection, the apparatus substantially as hereinbefore described with reference to Figures 2 to 4 of the accompanying drawings.
